# EUROPÄISCHE PATENTSCHRIFT

(11) **EP 2 924 721 B1**
(45) Veröffentlichungstag und Bekanntmachung des Hinweises auf die Patenterteilung: **22.04.2020**
(21) Anmeldenummer: 14199710.6
(22) Anmeldetag: 22.12.2014
(51) Int. Cl.: H01L 21/68

(54) **Positioniereinrichtung in Portalbauweise**
Positioning device in portal design
Dispositif de positionnement à portique

(30) Priorität: 25.03.2014 DE 102014205523
(43) Veröffentlichungstag der Anmeldung: 30.09.2015
(73) Patentinhaber: ETEL S.A., 2112 Môtiers (CH)
(72) Erfinder: Maamari, Nadim, 2000 Neuchâtel (CH); Coleman, Ralph, 2114 Fleurier (CH)
(74) Vertreter: Pleyer, Hans Anno

(56) Entgegenhaltungen:
- EP-A1- 1 975 981
- DE-A1-102008 010 284
- JP-A- 2007 109 810
- US-A1- 2004 178 327
- US-A1- 2005 255 624
- US-A1- 2008 094 592

## Beschreibung

### GEBIET DER TECHNIK

Die vorliegende Erfindung betrifft eine Positioniereinrichtung in Portalbauweise, mit zwei parallel verlaufenden, angetriebenen Linearachsen für eine erste Richtung, sowie einem entlang dieser Linearachsen verschiebbaren Querträger, der ein Funktionselement in einer zweiten Richtung verschiebbar hält, so dass das Funktionselement in oder parallel zu einer Ebene zwischen den beiden parallelen Linearachsen positionierbar ist.

Solche Positioniereinrichtungen werden auch als Portalantrieb oder X-Y-Gantry bezeichnet, und finden in vielen Bereichen der Technik Anwendung. Die Bearbeitung von flächigen Substraten wie Wafer oder Platinen ist ein typischer Anwendungsfall für solche Portalantriebe. Durch die fortschreitende Miniaturisierung wird auch hier eine immer bessere Positioniergenauigkeit verlangt.

### STAND DER TECHNIK

In der EP 2066996 B1 ist eine Positioniereinrichtung in Portalbauweise beschrieben, bei der zur genaueren Positionsbestimmung Positionsmesssysteme zum Einsatz kommen, die neben der Position in der eigentlichen Messrichtung entlang einer Linearführung auch kleine Abweichungen der Position in einer Richtung quer dazu erfassen können (also z.B. Führungsfehler). Hierzu dienen Maßstäbe, die neben der eigentlichen Messspur in der Messrichtung auch eine sogenannte Geradheitsspur tragen, an der solche kleinen Abweichungen quer zur Messrichtung abgelesen werden können. Solche Maßstäbe werden auch als 1Dplus - Maßstäbe bezeichnet, weil sie neben der Erfassung einer Messrichtung (1D) noch eine Messung in einer weiteren Richtung erlauben, wenn auch nur kleine Abweichungen in dieser Richtung. Solche Maßstäbe und entsprechende Positionsmesssysteme sind in der Firmenschrift HEIDENHAIN INFO, Electronics, Volume 1, 2009 näher beschrieben. Auch eine Anwendung solcher Maßstäbe an einer Positioniereinrichtung in Portalbauweise ist hier gezeigt.

Ein typischer 1Dplus - Maßstab trägt für die eigentliche Messrichtung eine Inkrementalspur oder allgemeiner eine Messspur, die aus feinen, kurzen Strichen quer zur Messrichtung bestehen kann, die beispielsweise optisch von einem relativ zum Maßstab beweglichen Abtastkopf abgetastet werden. Die Geradheitsspur besteht aus wenigen langen Strichen, die parallel zur eigentlichen Messrichtung (und damit quer zur Richtung der Führungsfehler) neben der Inkrementalspur liegen. Auch diese Geradheitsspur wird vom Abtastkopf abgetastet. Durch die Abtastung der Maßstabsspuren entstehen bei einer Relativbewegung zwischen Maßstab und Abtastkopf periodische Signale. Durch Zählen der Perioden und Unterteilen der einzelnen Perioden (Interpolation) kann so das Ausmaß der Verschiebung und damit eine Position festgestellt werden. Von einem 1Dplus - Maßstab können also Positionswerte in zwei voneinander unabhängigen Richtungen abgelesen werden.

Im Stand der Technik sind auch sogenannte Dual-Gantry - Anordnungen bekannt, bei denen zwischen den beiden Linearführungen in der ersten Richtung zwei verschiebbare Querträger angeordnet sind. So beschreibt die WO 02/067648 A1 eine Werkzeugmaschine zur Bearbeitung von Platinen mit gedruckten Schaltungen, die zur Steigerung der Produktivität einen zweiten Querträger mit zusätzlichen Bearbeitungswerkzeugen aufweist.

Aus der EP 1975981 A1 ist außerdem eine Belichtungsmaschine für Wafer bekannt, bei der zwei Tische mit einer Dual-Gantry - Anordnung bewegt werden. Einer der beiden Tische trägt den zu belichtenden Wafer, der andere Tisch trägt Sensoren, die das Licht der Belichtungsmaschine ausmessen können.

Es sind Anwendungen für solche Positioniereinrichtungen in Portalbauweise bekannt, bei denen ein auf einem beweglichen Tisch abgelegtes Substrat unter einem ortsfesten Werkzeug bewegt werden muss. Dabei wird eine Bewegungsrichtung schrittweise abgearbeitet (stepping), die andere Bewegungsrichtung mit einer kontinuierlichen Bewegung des Substrates (scanning). Die kontinuierliche Scan-Bewegung wird dabei längs des Querträgers der Positioniereinrichtung vorgenommen, die schrittweise Step-Bewegung längs der beiden parallelen Linearachsen. Für manche Anwendungen (z.B. Wafer-Inspektion mittels Hellfeldmikroskopie) wird dabei eine geradlinige Scan-Bewegung mit einer erlaubten Abweichung von höchstens 20 Nanometern von einer idealen Geraden gefordert.

Solche Genauigkeiten sind jedoch mit den existierenden Positioniereinrichtungen in Portalbauweise kaum zu erzielen. Der Wärmeintrag des Antriebes im Querträger und die zur Bewegung des Wafertisches notwendigen Kräfte verursachen eine Verformung und sogar Schwingungen der Strukturen der Positioniereinrichtung, die eine genaue Positionserfassung und damit auch eine genaue Positionsregelung unmöglich machen.

### ZUSAMMENFASSUNG DER ERFINDUNG

Es ist daher Aufgabe der Erfindung, eine Positioniereinrichtung in Portalbauweise zu schaffen, mit der eine besonders genaue Erfassung der Position des Funktionselements und dadurch dessen genaue Positionierung ermöglicht werden.

Diese Aufgabe wird gelöst durch eine Vorrichtung gemäß Anspruch 1. Vorteilhafte Details dieser Vorrichtung ergeben sich aus den von Anspruch 1 abhängigen Ansprüchen.

Es wird eine Positioniereinrichtung in Portalbauweise beschrieben, mit zwei auf einer Basis parallel zueinander angeordneten Linearführungen, die einen ersten Querträger und einen zweiten Querträger in einer ersten Richtung beweglich halten. Am ersten Querträger ist ein Laufwagen mit einem Funktionselement in einer zweiten Richtung beweglich gehalten. Am Laufwagen und am zweiten Querträger sind Positionsmesseinrichtungen zur Messung der Lage des Laufwagens relativ zum zweiten Querträger angeordnet.

Indem nun die Lage des Laufwagens relativ zu einem zweiten Querträger gemessen wird, der weder mechanisch noch thermisch beeinflusst wird, der also wesentlich formstabiler ist als der erste, den Laufwagen tragende Querträger, ist eine wesentlich genauere Erfassung der räumlichen Lage des Laufwagens möglich. Mittels zusätzlicher Antriebe zur Feinpositionierung, die zwischen dem Laufwagen und dem Funktionselement wirken, ist somit eine genauere Positionierung des Funktionselements in allen Freiheitsgraden möglich, unabhängig von einer Verformung des ersten Querträgers.

Weitere Vorteile und Einzelheiten der vorliegenden Erfindung ergeben sich aus der nachfolgenden Beschreibung verschiedener Ausführungsformen anhand der Figuren.

### KURZE BESCHREIBUNG DER ZEICHNUNGEN

Dabei zeigt
- Figur 1: eine herkömmliche Positioniereinrichtung in Portalbauweise,
- Figur 2: eine erfindungsgemäße Positioniereinrichtung in Portalbauweise,
- Figur 3: ein als Bezugssystem dienender zweiter Querträger der Positioniereinrichtung,
- Figur 4: einen Laufwagen der Positioniereinrichtung,
- Figur 5: die Basis der Positioniereinrichtung, mit Maßstäben zur Feststellung der Lage des als Bezugssystem dienenden zweiten Querträgers relativ zur Basis,
- Figur 6: eine Schiene mit Maßstäben zur Feststellung der Lage des als Bezugssystem dienenden zweiten Querträgers relativ zur Schiene.

### BESCHREIBUNG DER AUSFÜHRUNGSFORMEN

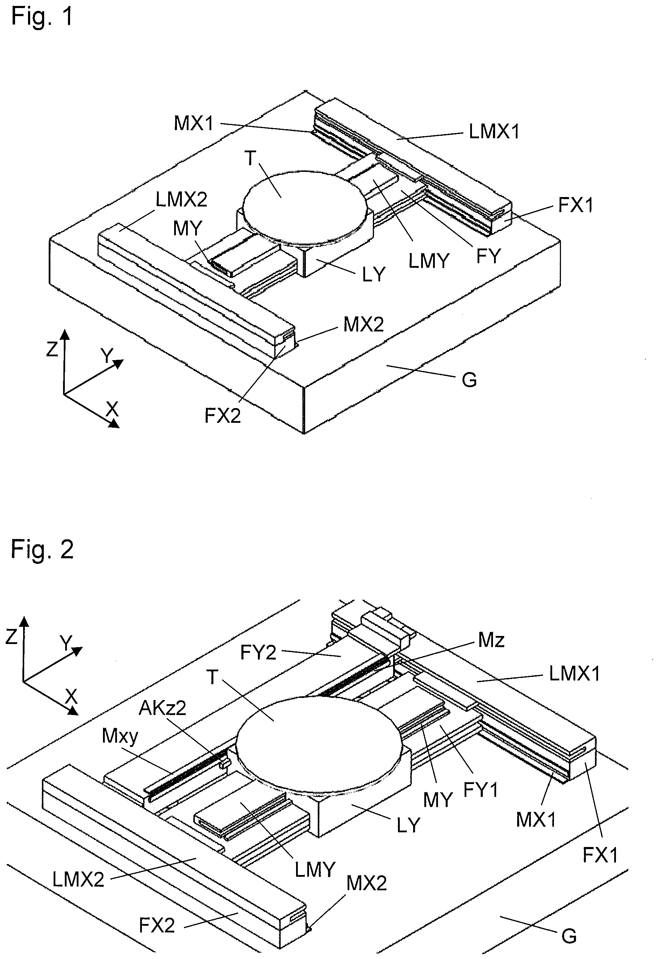

Die Figur 1 zeigt eine herkömmliche Positioniereinrichtung in Portalbauweise. Auf einer zum Beispiel als Granitblock ausgeführten Basis G sind zwei parallele Linearführungen FX1, FX2 angeordnet, die einen Querträger FY in X-Richtung verschiebbar halten. Zum Bewegen des Querträgers FY dienen zwei Linearmotoren LMX1, LMX2, die parallel zu den Linearführungen FX1, FX2 liegen oder in diese integriert sind. Am Querträger FY ist ein Laufwagen LY in Y-Richtung mittels eines weiteren Linearmotors LMY verschiebbar geführt.

Der Laufwagen LY trägt als Funktionselement einen Tisch T, auf dem beispielsweise ein Wafer abgelegt werden kann, der dann über ein ortsfest oberhalb der Positioniereinrichtung angeordnetes Werkzeug bearbeitet oder inspiziert werden kann.

Die Positionierung der Linearachsen in X- und Y-Richtung erfolgt anhand von Maßstäben MX1, MX2, MY entlang der jeweiligen Führungen FX1, FX2, FY, die von hier nicht dargestellten Abtastköpfen abgetastet werden, um die jeweils aktuelle Position aller Achsen zu ermitteln. Über herkömmliche Positionsregler werden alle beweglichen Achsen auf die jeweiligen Positionssollwerte geregelt und so der Tisch T in der X-Y-Ebene positioniert.

Der Laufwagen LY einer solchen herkömmlichen Positioniereinrichtung ruht üblicherweise auf Luftlagern auf dem Granit. Dies impliziert, dass sich der Laufwagen gegenüber dem Querträger FY in den Freiheitsgraden Rotation um die X- und Y-Richtung sowie lineare Verschiebung in Z-Richtung beweglich sein muss. Die Ebenheit des Granits bestimmt dann die Ebenheit der Bewegung des Laufwagens LY.

Die Figur 2 zeigt nun eine Positioniereinrichtung in Portalbauweise gemäß der Erfindung. Als wesentlichen Unterschied erkennt man sofort den zweiten Querträger FY2. Zur besseren Unterscheidung ist in dieser Figur der den Laufwagen LY tragende Querträger als erster Querträger FY1 bezeichnet, ansonsten sind die dem Stand der Technik entsprechenden Elemente wie in der Figur 1 bezeichnet und hier nicht nochmals erklärt.

Der zweite Querträger FY2 verfügt über eigene Antriebe für die X-Richtung, kann also vom ersten Querträger FY1 unabhängig positioniert werden. Er wird jedoch von seinem Positionsregler in einem festen Abstand zum ersten Querträger FY1 gehalten. Dieser Abstand muss so genau eingehalten werden, dass die weiter unten beschriebene Positionsmesseinrichtung zur Erfassung der Lage des Laufwagens LY relativ zum zweiten Querträger FY2 zuverlässig ausgewertet werden kann. Die Abstandstoleranz der Positionsmesseinrichtung, innerhalb der eine Auswertung noch möglich ist, liegt typischerweise bei etwa 200 Mikrometern.

Im Laufwagen LY sind Antriebe untergebracht, die eine Feinpositionierung des Tisches T während der Scan-Bewegung des Laufwagens LY ermöglichen. Diese Feinpositionierung muss zumindest für die Rotationen um die X- und Y-Achse möglich sein, sowie für die Z-Richtung. Die Positionskorrektur in X und Y, sowie die Rotation um die Z-Achse können auch mit den Antrieben der Positioniereinrichtung in Portalbauweise erfolgen. So können Abweichungen von einer gewünschten Scan-Bewegung in allen sechs Freiheitsgraden korrigiert werden, die zu diesem Zweck jedoch gemessen werden müssen.

Als Bezugssystem für diese Positions- bzw. Lagemessung dient dabei der zweite Querträger FY2, der deswegen hier auch als bewegliches Bezugssystem bezeichnet wird. Der Vorteil dieser Lösung ist, dass durch die Scan-Bewegungen des Laufwagens LY keine Kräfte auf den zweiten Querträger FY2 ausgeübt werden, und auch dass die Antriebe des ersten Querträgers FY1 keine Wärme in den zweiten Querträger FY2 einbringen.

Wartet man eine gewisse Zeit nach jeder Positionsänderung (Step-Bewegung) des ersten und zweiten Querträgers FY1, FY2 ab, so dass Schwingungen des zweiten Querträgers FY2 abgeklungen sind, kann dieser als ortsfest gelten. Da der zweite Querträger FY2 keinen Laufwagen trägt, kann er besonders leicht ausgeführt sein, wodurch seine Resonanzfrequenzen besonders hoch liegen und Schwingungen nach einer Step-Bewegung schnell abklingen.

Stellt man die genaue Lage des zweiten Querträgers FY2 relativ zur Basis G fest (dazu später mehr), eignet er sich während der Scan-Bewegung des Laufwagens LY bzw. des Tisches T als Bezugssystem für die Positionsmessung des Laufwagens LY in allen Freiheitsgraden. Misst man also die Position des Laufwagens LY direkt in Bezug auf den zweiten Querträger FY2 in allen Freiheitsgraden, können Verformungen des ersten Querträgers FY1 (durch Beschleunigungskräfte, das Gewicht des Laufwagens, Temperatureinflüsse, Schwingungen...) erkannt und über die zur Verfügung stehenden Antriebe (der Feinpositionierung des Tisches T und/oder der Achsen der Positioniereinrichtung in Portalbauweise) ausgeregelt werden.

Um wirklich jede Rückwirkung vom ersten Querträger FY1 auf den zweiten Querträger FY2 auszuschließen, sollten Schwingungen der Basis G aktiv gedämpft werden, so dass nicht nur Schwingungen von außen abgeschirmt werden, sondern auch solche, die von den Prozesskräften des ersten Querträgers FY1 und zweiten Querträgers FY2 in die Basis G eingeleitet werden.

Zur Positionsbestimmung des Laufwagens LY relativ zum zweiten Querträger FY2 erkennt man am zweiten Querträger Maßstäbe Mxy, Mz, sowie am Laufwagen einen Abtastkopf AKz2. Weitere Maßstäbe und Abtastköpfe sind in dieser Darstellung nicht zu erkennen, eine Möglichkeit für deren Anordnung wird daher in den nächsten Figuren näher erläutert.

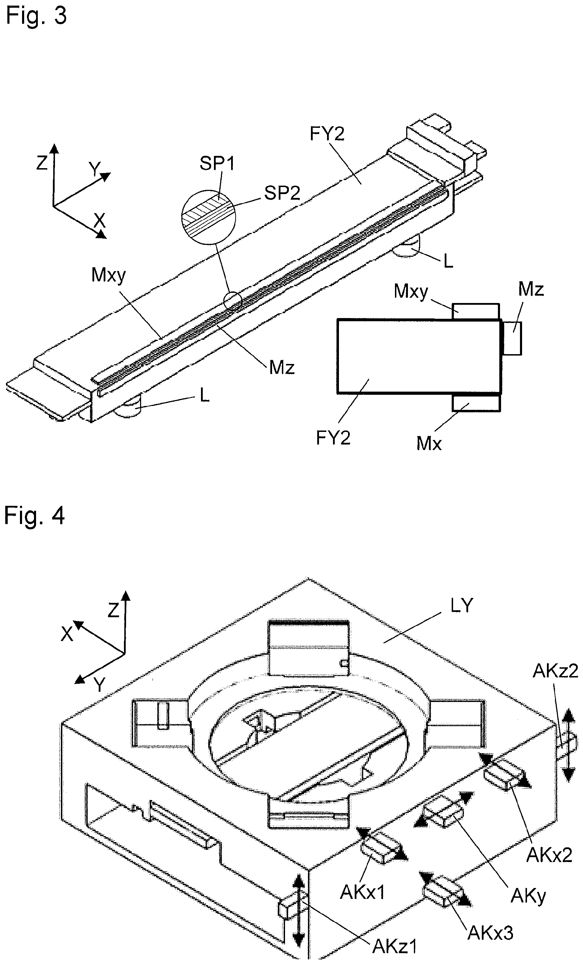

In Figur 3 ist der zweite Querträger FY2 separat dargestellt, zusammen mit einem schematischen Schnitt durch die X-Z-Ebene. Der zweite Querträger FY2 stützt sich in Z-Richtung auf drei aerostatische, mittels Vakuum vorgespannte Luftlager L auf dem Granit ab, und in Y-Richtung über ein weiteres (nicht dargestelltes) Luftlager an einer vertikalen Fläche des Granits entlang der ersten Linearführung FX1. Auch dieses vierte Luftlager für die Y-Richtung ist mittels Vakuum vorgespannt. Die insgesamt vier Luftlager L blockieren vier Freiheitsgrade des zweiten Querträgers FY2, es handelt sich also um eine isostatische Lagerung, durch die eine Krafteinleitung bei der Bewegung des Querträgers FY2 auf dem nicht perfekt ebenen Granit vermieden wird. Die beiden übrigen Freiheitsgrade (X und Rotation um Z) des zweiten Querträgers FY2 werden durch dessen Antriebe entlang der Linearführungen FX1, FX2 kontrolliert. Durch die Vorspannung aller Luftlager L mittels Vakuum kompensieren sich alle antagonistischen Kräfte innerhalb der Luftlager L, es werden durch sie keine Kräfte in den zweiten Querträger FY2 eingeleitet.

Auf dem zweiten Querträger FY2 sind 3 Maßstäbe Mxy, Mz und Mx angeordnet. Auf der der Basis G abgewandten Oberseite des Querträgers FY2 findet sich ein sogenannter 1Dplus - Maßstab Mxy mit Inkrementalteilungen in X- und Y-Richtung, also in den beiden zur Basis G parallelen Richtungen. Im vergrößerten Ausschnitt erkennt man eine Messspur SP1 und eine Geradheitsspur SP2. Auf der dem ersten Querträger FY1 zugewandten Stirnseite des zweiten Querträgers FY2 ist ein Maßstab Mz angeordnet, der eine Inkrementalteilung in Z-Richtung aufweist. Dabei kann es sich um einen weiteren 1Dplus - Maßstab handeln, dessen Geradheitsspur dann die Inkrementalteilung in Z-Richtung ist, denn die Teilungsstriche verlaufen quer zur Z-Richtung in Y-Richtung. Die eigentliche Messspur dieses Maßstabes Mz in Y-Richtung wird im hier gezeigten Ausführungsbeispiel nicht abgetastet. Auf der der Basis G zugewandten Unterseite des Querträgers FY2 ist ein dritter Maßstab Mx angeordnet, der eine Inkrementalteilung in X-Richtung trägt. Auch hierfür kann ein 1Dplus - Maßstab verwendet werden, dessen eigentliche Messspur in Y-Richtung hier nicht benötigt wird.

Die Maßstäbe Mxy, Mz und Mx auf dem zweiten Querträger FY2 dienen wie oben beschrieben zur Erfassung der Lage des Laufwagens LY relativ zum zweiten Querträger FY2, und zwar in allen sechs Freiheitsgraden. Die Abtastköpfe zur Abtastung der Maßstäbe Mxy, Mz und Mx sind daher am Laufwagen LY angebracht.

Die Figur 4 zeigt den Laufwagen LY, und zwar im Vergleich zur Figur 2 um 180 Grad um die Z-Achse gedreht, um alle für die Abtastung der Maßstäbe Mxy, Mz, Mx benötigten Abtastköpfe erkennen zu können:
- Die Rotation des Laufwagens LY um die Z-Achse kann aus der Differenz der X-Positionen berechnet werden, die von den Abtastköpfen AKx1 und AKx2 vom Maßstab Mxy abgelesen werden. Die Abtastköpfe AKx1 und AKx2 lesen dabei die Geradheitsspur vom Maßstab MXY ab, die aus wenigen langen Strichen in Y-Richtung besteht.
- Die Rotation des Laufwagens LY um die Y-Achse kann aus einer Kombination der X-Positionen berechnet werden, die von den Abtastköpfen AKx1, AKx2 und AKx3 vom Maßstab Mxy bzw. Maßstab Mx abgelesen werden. Die Abtastköpfe AKx1, AKx2 und AKx3 lesen dabei die Geradheitsspuren der Maßstäbe Mxy und Mx ab, die jeweils aus wenigen langen Strichen in Y-Richtung bestehen.
- Die Rotation des Laufwagens LY um die X-Achse kann aus der Differenz der Z-Positionen berechnet werden, die von den Abtastköpfen AKz1 und AKz2 vom Maßstab Mz abgelesen werden. Die Abtastköpfe AKz1 und AKz2 lesen dabei die Geradheitsspur des Maßstabs Mz ab, die aus wenigen langen Strichen in Y-Richtung besteht.
- Die Position des Laufwagens LY in X-Richtung ergibt sich aus dem Mittelwert der anhand der Abtastköpfe AKx1 und AKx2 ermittelten X-Positionen.
- Die Position des Laufwagens LY in Z-Richtung ergibt sich aus dem Mittelwert der anhand der Abtastköpfe AKz1 und AKz2 ermittelten Z-Positionen.
- Die Position des Laufwagens LY in Y-Richtung ergibt sich aus der anhand des Abtastkopfes AKy ermittelten Y-Position, wobei eine zuvor bestimmte Rotation um die Z-Achse berücksichtigt werden muss.

Mit der beschriebenen Anordnung von 1Dplus - Maßstäben Mxy, Mz, Mx am zweiten Querträger FY2 und der Anordnung von Abtastköpfen AKy, AKx1, AKx2, AKx3, AKz1, AKz2 am Laufwagen LY lässt sich die Lage des Laufwagens LY relativ zum zweiten Querträger FY2 in allen Freiheitsgraden bestimmen. Dabei sind andere Anordnungen und Kombinationen von Maßstäben und Abtastköpfen möglich, solange sie nur ebenfalls die vollständige Ermittlung aller sechs Freiheitsgrade ermöglichen. Als Beispiel für eine andere Anordnung der Abtastköpfe sei hier lediglich die Ermittlung der Position in Y-Richtung genannt, die durch Abtastung der eigentlichen Messspur von jedem beliebigen der drei 1Dplus - Maßstäbe Mxy, Mz, Mx gewonnen werden kann. Es ist vorteilhaft, wenn wenigstens einer der drei Maßstäbe Mxy, Mz, Mx als 1Dplus - Maßstab ausgebildet ist, da von so einem Maßstab Positionsmesswerte in zwei verschiedenen Richtungen abgetastet werden können, wie im vorliegenden Beispiel vom Maßstab Mxy.

Kennt man die räumliche Lage des Laufwagens LY, und betrachtet man diesen als starren Körper, so lässt sich die räumliche Lage jedes Punktes des Laufwagens LY (also z.B. des Tool Center Points eines mit dem Laufwagen verbundenen Werkzeugs oder die Mitte eines Wafer-Tisches) durch geometrische Transformationen ermitteln.

Damit die Abtastköpfe AKy, AKx1, AKx2, AKx3, AKz1, AKz2 jederzeit die Maßstäbe Mxy, Mz, Mx ablesen können, muss der Abstand zwischen den beiden Querträgern FY1 und FY2 so genau eingestellt und eingehalten werden, dass eine korrekte Auswertung der Signale der Abtastköpfe jederzeit möglich ist, entsprechend der weiter oben erwähnten Abstandstoleranz von etwa 200 Mikrometern.

Die Positionserfassung zwischen dem Laufwagen LY und dem zweiten Querträger FY2 erfolgt berührungslos, z.B. durch Abtastung der Maßstäbe Mxy, Mz, Mx mit Licht. Es wirkt daher keine Kraft auf den zweiten Querträger FY2, der auch sonst dank seiner Luftlagerung auf einem möglichst gut schwingungsisolierten Granit (der Basis G) ruht. Im Gegensatz zum ersten Querträger FY1 ist der zweiten Querträger FY2 während einer Scan-Bewegung in Y-Richtung keinerlei Prozesskräften oder thermischen Einflüssen ausgesetzt, die ihn verformen könnten. Kennt man also durch eine externe Kalibrierung die Form des zweiten Querträgers möglichst genau, und bestimmt man seine Lage innerhalb eines absoluten Bezugssystems (das z.B. durch die Basis G gegeben sein kann), so lässt sich auch die Position des Laufwagens LY relativ zu diesem absoluten Bezugssystem ermitteln.

Während einer Scan-Bewegung entlang des ersten Querträgers FY1 ist es dann möglich, alle Abweichungen der räumlichen Lage des Laufwagens LY zu erfassen, und somit die räumliche Lage des Funktionselements T über nicht dargestellte Antriebe zur Feinpositionierung des Funktionselements T bzw. über die Antriebe in den Linearführungen FX1, FX2 und FY1 zu korrigieren. Die Antriebe zur Feinpositionierung finden in den auf der Oberseite des Laufwagens FY zu erkennenden Aussparungen Platz.

Da die Lage des Laufwagens LY in allen Freiheitsgraden gemessen und die räumliche Lage des Funktionselements T entsprechend aktiv korrigiert wird, ist eine Luftlagerung des Laufwagens LY auf der Basis nicht mehr unbedingt nötig, aber natürlich dennoch möglich. Ohne Luftlagerung kann der Laufwagen LY fest mit dem ersten Querträger FY1 verbunden werden, mit der Beweglichkeit in Y-Richtung als einzigem Freiheitsgrad. Es ist dann im Gegensatz zum Stand der Technik nicht notwendig, einen besonders ebenen und damit entsprechend teuren Granit als Basis B zu verwenden.

Ist das absolute Bezugssystem durch die Basis G gegeben, so kann die Lage des zweiten Querträgers FY2 (der als bewegliches Bezugssystem dient) zu diesem absoluten Bezugssystem durch ein geeignetes Lagemesssystem ermittelt werden.

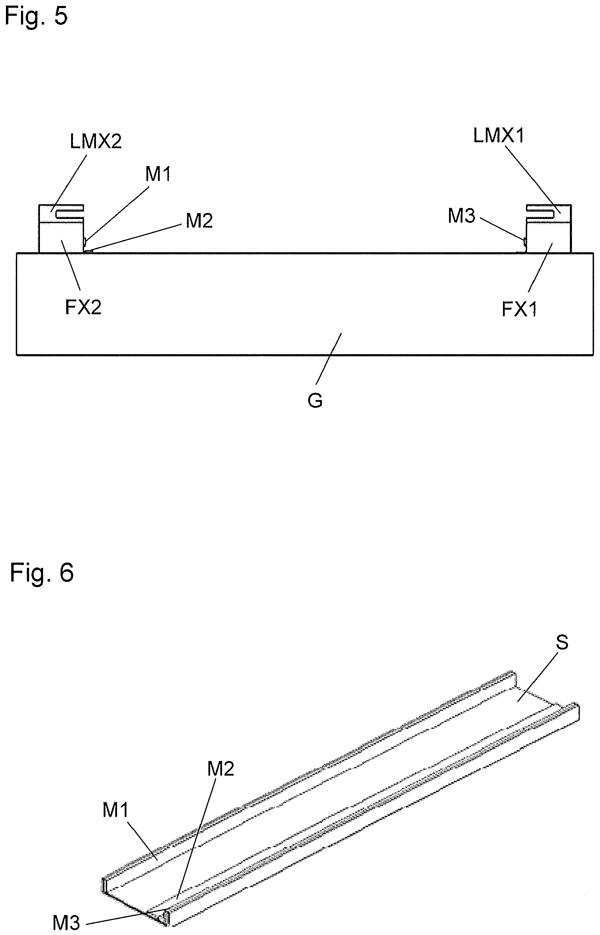

In der Figur 5 ist angedeutet, wie so ein Lagemesssystem für die Lage des zweiten Querträgers FY2 relativ zur Basis G aufgebaut sein kann. An der Basis G oder mit dieser fest verbunden sind drei 1Dplus Maßstäbe M1, M2, M3 angeordnet, so dass deren Teilungsspuren unterschiedliche Richtungen X, Y, Z abdecken. Von mehreren am zweiten Querträger FY angeordneten Abtastköpfen werden diese Teilungsspuren abgelesen, und die so ermittelten Positionswerte zur Berechnung der räumlichen Lage des zweiten Querträgers FY relativ zur Basis herangezogen, wobei wieder alle sechs Freiheitsgrade zu berücksichtigen sind. Da es auch hier viele Möglichkeiten gibt, Abtastköpfe geeignet am zweiten Querträger FY2 anzuordnen, wurde auf die Darstellung einer konkreten Anordnung verzichtet.

Alternativ können die drei Maßstäbe M1, M2, M3 auch an jeder anderen Struktur angebracht werden, die als absolutes Bezugssystem für die Positionierung des Funktionselements T gelten soll. So werden sehr empfindliche optische Anordnungen zur Bearbeitung oder Inspektion von Wafern oft an einer Plattform angeordnet, die nicht mit der Basis einer zugeordneten Positioniereinrichtung verbunden ist, um eine Deformation der Optik durch einen schwingenden Granit zu vermeiden. Dadurch können zwischen dem Granit und der Plattform Verschiebungen im Bereich einiger Mikrometer auftreten. In solchen Fällen ist es besser, diese Plattform als absolutes Bezugssystem zu verwenden.

So zeigt die Figur 6 eine Schiene S mit einem U-Profil, in dem wiederum drei 1Dplus - Maßstäbe M1, M2, M3 zur Abtastung von an dem zweiten Querträger FY2 angeordneten Abtastköpfen angebracht sind. Diese mit sehr geringen Toleranzen gefertigte und formstabile Schiene kann beispielsweise seitlich an die optische Plattform angeschraubt werden, die oberhalb der Positioniereinrichtung in Portalbauweise angeordnet ist, und bezüglich der das Funktionselement T positioniert werden soll. Die Abtastköpfe zur Abtastung der Maßstäbe M1, M2, M3 müssen dabei so am zweiten Querträger FY2 montiert sein, dass sie in jeder X - Position des zweiten Querträgers FY2 Positionswerte liefern können.

Kennt man also die Form des zweiten Querträgers FY2 und seine Lage relativ zum absoluten Bezugssystems genau, kann man durch die Messung der räumlichen Lage des Laufwagens LY relativ zum zweiten Querträger FY2 auf die räumliche Lage des Laufwagens LY relativ zum absoluten Bezugssystem schließen. Eine Scan-Bewegung des Tisches T auf einer im absoluten Bezugssystem vorgegebenen Scan - Linie kann somit sehr genau ausgeführt werden, unabhängig von einer Verformung des ersten Querträgers FY1, auf dem der Laufwagen LY geführt wird. Die negativen Effekte der Antriebskräfte und deren Wärmeeintrag und die damit verbundene Verformung des ersten Querträgers FY1 werden eliminiert, indem die resultierende Fehlpositionierung des Laufwagens LY in allen Freiheitsgraden gemessen und für den Tisch T korrigiert wird. Ein auf dem Tisch T abgelegter Wafer kann also sehr genau die geforderte Scan-Bewegung einhalten und dabei seine Orientierung in allen übrigen Freiheitsgraden beibehalten.

Folgende Schritte ermöglichen also eine sehr genaue Scan-Bewegung des Tisches T:
a) Falls der als bewegliches Bezugssystem dienende zweite Querträger FY2 nicht ausreichend gerade ist, wird dessen Form durch eine externe Kalibrierung ermittelt und das Ergebnis zur späteren Berücksichtigung gespeichert.
b) Erster und zweiter Querträger FY1, FY2 werden für jede Step-Bewegung parallel verschoben. Es wird dann abgewartet, bis Schwingungen des zweiten Querträgers FY2 abgeklungen sind.
c) Die Position des zweiten Querträgers FY2 relativ zum absoluten Bezugssystem wird festgestellt, denn letztlich soll der Tisch T eine Scan-Bewegung innerhalb dieses absoluten Bezugssystems durchführen, unter möglichst genauer Kontrolle seiner sechs Freiheitsgrade.
d) Während der Scan-Bewegung des Laufwagens LY wird die räumliche Lage des Laufwagens LY relativ zum zweiten Querträger FY2 in allen sechs Freiheitsgraden ermittelt. Hierzu werden mit den am Laufwagen LY befestigten Abtastköpfen AKy, AKx1, AKx2, AKx3, AKz1, AKz2 Positionen von den am zweiten Querträger FY2 befestigten Maßstäben Mxy, Mz, Mx abgelesen. Auf diese Weise wird die Lage des Laufwagens LY relativ zum zweiten Querträger FY2 (der als bewegliches Bezugssystem dient) in allen Freiheitsgraden festgestellt. Da die Lage (und ggf. aus Schritt a) auch die genaue Form) des zweiten Querträgers FY2 relativ zum absoluten Bezugssystem bekannt ist, kann die Lage des Laufwagens LY bezüglich des absoluten Bezugssystems in allen sechs Freiheitsgraden ermittelt werden.
e) Für das Funktionselement, also hier für den Tisch T, können vor allem auf einer Verformung des ersten Querträgers FY1 beruhende Lageabweichungen des Laufwagens LY mit den Antrieben zur Feinpositionierung bzw. mit den Antrieben der Positioniereinrichtung in Portalbauweise ausgeregelt werden. Das Funktionselement kann also bezüglich des absoluten Bezugssystems sehr genau positioniert werden.

## Patentansprüche

1. Positioniereinrichtung in Portalbauweise, mit zwei auf einer Basis (G) parallel zueinander angeordneten Linearführungen (FX1, FX2), die einen ersten Querträger (FY1) und einen zweiten Querträger (FY2) in einer ersten Richtung (X) beweglich halten, wobei am ersten Querträger (FY1) ein Laufwagen (LY) mit einem Funktionselement (T) in einer zweiten Richtung (Y) beweglich gehalten ist, **dadurch gekennzeichnet, dass** am Laufwagen (LY) und am zweiten Querträger (FY2) eine Positionsmesseinrichtung mit Maßstäben (Mxy, Mz, Mx) und Abtastköpfen (AKx1, AKx2, AKx3, AKy, AKz1, AKz2) zur Erfassung der Lage des Laufwagens (LY) relativ zum zweiten Querträger (FY2) angeordnet ist, und dass eine Lagemesseinrichtung (M1, M2, M3) die Erfassung der Lage des zweiten Querträgers (FY2) relativ zu einem absoluten Bezugssystem ermöglicht, so dass der zweite Querträger (FY2) als bewegliches Bezugssystem bei der Feststellung der räumlichen Lage des Laufwagens (LY) relativ zum absoluten Bezugssystem dient.

2. Positioniereinrichtung nach Anspruch 1, **dadurch gekennzeichnet, dass** die Positionsmesseinrichtung (Mxy, Mz, Mx, AKx1, AKx2, AKx3, AKy, AKz1, AKz2) eine Feststellung der räumlichen Lage des Laufwagens (LY) relativ zum zweiten Querträger (FY2) in allen sechs Freiheitsgraden ermöglicht.

3. Positioniereinrichtung nach Anspruch 1 oder 2, **dadurch gekennzeichnet, dass** am zweiten Querträger (FY2) mehrere der Maßstäbe (Mxy, Mz, Mx) angeordnet sind, die von den Abtastköpfen (AKx1, AKx2, AKx3, AKy, AKz1, AKz2) am Laufwagen (LY) abgetastet werden.

4. Positioniereinrichtung nach Anspruch 3, **dadurch gekennzeichnet, dass** wenigstens einer der Maßstäbe (Mxy) am zweiten Querträger (FY2) ein 1Dplus - Maßstab mit einer Messspur (SP1) und einer Geradheitsspur (SP2) ist, auf den Abtastköpfe (AKx1, AKx2, AKy) des Laufwagens (LY) ausgerichtet sind, um Positionswerte in zwei linear voneinander unabhängigen Richtungen (X,Y) abzulesen.

5. Positioniereinrichtung nach einem der vorhergehenden Ansprüche, **dadurch gekennzeichnet, dass** die Basis (G) aktiv schwingungsgedämpft ist.

6. Positioniereinrichtung nach einem der vorhergehenden Ansprüche, **dadurch gekennzeichnet, dass** die Lagemesseinrichtung (M1, M2, M3) zur Erfassung der Lage des zweiten Querträgers (FY2) wenigstens einen 1Dplus - Maßstab mit einer Messspur (SP1) und einer Geradheitsspur (SP2) aufweist.

7. Positioniereinrichtung nach einem der vorhergehenden Ansprüche, **dadurch gekennzeichnet, dass** zwischen dem Laufwagen (LY) und dem Funktionselement (T) wirkende Antriebe zur Feinpositionierung eine Korrektur der räumlichen Lage des Funktionselements (T) wenigstens in den Freiheitsgraden lineare Verschiebung in einer zur ersten und zweiten Richtung (X, Y) senkrechten Richtung (Z), Rotation um die erste Richtung (X) und Rotation um die zweite Richtung (Y) ermöglichen.

8. Positioniereinrichtung nach Anspruch 7, **dadurch gekennzeichnet, dass** die Antriebe zur Feinpositionierung so ansteuerbar sind, dass Fehlstellungen des Laufwagens (LY) ausgeglichen werden.

## Claims

1. Gantry-type positioning device having two linear guides (FX1, FX2) arranged parallel to one another on a base (G) and holding a first transverse support (FY1) and a second transverse support (FY2) movable in a first direction (X), wherein a carriage (LY) with a function element (T) is held on the first transverse support (FY1) movable in a second direction (Y), **characterized in that** a position measuring device with scales (Mxy, Mz, Mx) and scanning heads (AKx1, AKx2, AKx3, AKy, AKz1, AKz2) for detecting the position of the carriage (LY) relative to the second transverse support (FY2) is mounted on the carriage (LY) and on the second transverse support (FY2), and that a position measuring device (M1, M2, M3) enables the detection of the position of the second transverse support (FY2) relative to an absolute reference system, so that the second transverse support (FY2) serves as a movable reference system when establishing the spatial position of the carriage (LY) relative to the absolute reference system),

2. Positioning device according to Claim 1, **characterized in that** the position measuring device (Mxy, Mz, Mx, AKx1, AKx2, AKx3, AKy, AKz1, AKz2) enables the establishment of the spatial position of the carriage (LY) relative to the second transverse support (FY2) in all six degrees of freedom.

3. Positioning device according to Claim 1 or 2, **characterized in that** several of the scales (Mxy, Mz, Mx) which are scanned by the scanning heads (AKx1, AKx2, AKx3, AKy, AKz1, AKz2) on the carriage (LY) are arranged on the second transverse support (FY2).

4. Positioning device according to Claim 3, **characterized in that** at least one of the scales (Mxy) on the second transverse support (FY2) is a 1Dplus scale with a measuring track (SP1) and a straightness track (SP2) to which scanning heads (AKx1, AKx2, AKy) of the carriage (LY) are aligned in order to read position values in two directions (X,Y) which are linearly independent of one another.

5. Positioning device according to one of the preceding claims, **characterized in that** the base (G) is actively vibration-damped.

6. Positioning device according to one of the preceding claims **characterized in that** the position measuring device (M1, M2, M3) for detecting the position of the second transverse support (FY2) has at least one 1Dplus scale with a measuring track (SP1) and a straightness track (SP2).

7. Positioning device according to one of the preceding claims **characterized in that** drives acting between the carriage (LY) and the function element (T) for fine positioning enable a correction of the spatial position of the function element (T) at least in the degrees of freedom, linear displacement in a direction (Z) perpendicular to the first and second direction (X, Y), rotation about the first direction (X) and rotation about the second direction (Y).

8. Positioning device according to Claim 7 **characterized in that** the drives for fine positioning are controllable so that faulty positions of the carriage (LY) are compensated.

## Revendications

1. Dispositif de positionnement dans un mode construction portail, comprenant deux guides linéaires (FX1, FX2) qui sont disposés parallèlement l'un à l'autre sur une base (G) et qui maintiennent une première traverse (FY1) et une deuxième traverse (FY2) mobiles dans une première direction (X), un chariot (LY) pourvu d'un élément fonctionnel (T) étant maintenu mobile dans une deuxième direction (Y) sur la première traverse (FY1), **caractérisé en ce qu'**un dispositif de mesure de position, pourvu d'échelles (Mxy, Mz, Mx) et de têtes de balayage (AKx1, AKx2, AKx3, AKy, AKz1, AKz2) destinées à détecter la position du chariot (LY) par rapport à la deuxième traverse (FY2), est disposé sur le deuxième chariot (LY) et sur la deuxième traverse (FY2) et **en ce qu'**un dispositif de mesure de position (M1, M2, M3) permet de détecter la position de la deuxième traverse (FY2) par rapport à un système de référence absolu de sorte que la deuxième traverse (FY2) sert de système de référence mobile lors de la détermination de la position spatiale du chariot (LY) par rapport au système de référence absolu.

2. Dispositif de positionnement selon la revendication 1, **caractérisé en ce que** le dispositif de mesure de position (Mxy, Mz, Mx, AKx1, AKx2, AKx3, AKy, AKz1, AKz2) permet de déterminer la position spatiale du chariot (LY) par rapport à la deuxième traverse (FY2) dans les six degrés de liberté.

3. Dispositif de positionnement selon la revendication 1 ou 2, **caractérisé en ce qu'**une pluralité d'échelles (Mxy, Mz, Mx) sont disposées sur la deuxième traverse (FY2), lesquelles échelles sont balayées par des têtes de balayage (AKx1, AKx2, AKx3, AKy, AKz1, AKz2) situées sur le chariot (LY).

4. Dispositif de positionnement selon la revendication 3, **caractérisé en ce que** l'une au moins des échelles (Mxy) sur la deuxième traverse (FY2) est une échelle 1Dplus pourvue d'une piste de mesure (SP1) et d'une piste de rectitude (SF2) sur lesquelles sont orientées des têtes de balayage (AKx1, AKx2, AKy) du chariot (LY) pour lire des valeurs de position dans deux directions (X, Y) linéairement indépendantes.

5. Dispositif de positionnement selon l'une des cations précédentes, **caractérisé en ce que** la base (G) est activement amortie en vibrations.

6. Dispositif de positionnement selon l'une des revendications précédentes, **caractérisé en ce que**, pour détecter la position de la deuxième traverse (FY2), le dispositif de mesure de position (M1, M2, M3) comporte au moins une échelle 1Dplus pourvue d'une piste de mesure (SP1) et d'une piste de rectitude (SP2).

7. Dispositif de positionnement selon l'une des revendications précédentes, **caractérisé en ce que** des entraînements, agissant entre le chariot (LY) et l'élément fonctionnel (T) et destinés au positionnement fin, permettent une correction de la position spatiale de l'élément fonctionnel (T) au moins dans les degrés de liberté, un déplacement linéaire dans une direction (Z) perpendiculaire aux première et deuxième directions (X, Y), une rotation autour de la première direction (X) et une roration autour de la deuxième direction (Y).

8. Dispositif de positionnement selon la revendication 7, **caractérisé en ce que** les entraînements de positionnement fin peuvent être commandés de manière à compenser des positions incorrectes du chariot (LY).
